# EUROPEAN PATENT SPECIFICATION

(11) **EP 3 761 348 B1**
(45) Date of publication and mention of the grant of the patent: **27.03.2024**
(21) Application number: 19184721.9
(22) Date of filing: 05.07.2019
(51) Int. Cl.: H01L 21/67, H01L 21/677

(54) **SYSTEM FOR CONVEYING A SUBSTRATE BETWEEN PROCESSING STATIONS OF A PROCESSING APPARATUS, PROCESSING APPARATUS AND METHODS OF HANDLING A SUBSTRATE**
SYSTEM ZUM FÖRDERN EINES SUBSTRATS ZWISCHEN VERARBEITUNGSSTATIONEN EINER VERARBEITUNGSVORRICHTUNG, VERARBEITUNGSVORRICHTUNG UND VERFAHREN ZUR HANDHABUNG EINES SUBSTRATS
SYSTÈME DE TRANSPORT D'UN SUBSTRAT ENTRE STATIONS DE TRAITEMENT D'UN APPAREIL DE TRAITEMENT, APPAREIL DE TRAITEMENT ET PROCÉDÉS DE MANIPULATION D'UN SUBSTRAT

(43) Date of publication of application: 06.01.2021
(73) Proprietor: Atotech Deutschland GmbH & Co. KG, 10553 Berlin (DE)
(72) Inventor: Hahn, Roland, 10553 Berlin (DE); Arnsperger, Johannes, 10553 Berlin (DE); Lorenz, Olaf, 10553 Berlin (DE); Weinhold, Ray, 10553 Berlin (DE)
(74) Representative: MKS IP Association

(56) References cited:
- US-A1- 2014 245 954
- US-A1- 2015 013 905
- US-A1- 2018 266 009
- US-B2- 9 388 504

## Description

### Technical Field

The invention relates to a system for conveying an object comprising at least a substrate between processing stations of a processing apparatus, comprising:
a transporter, arranged for movement from processing station to processing station,
wherein the transporter comprises a support part and a holding component for releasably holding the object; and
at least one object movement device for moving the object along a path predominantly directed in parallel to a reference axis in a reference co-ordinate system,
wherein each object movement device is associated with a respective processing station and capable of moving the object along the path towards the transporter to a transfer position and towards the associated processing station from the transfer position, and
wherein the holding component is configured to release and engage the object in the transfer position when the transporter is positioned at the processing station.

The invention also relates to a processing apparatus.

The invention also relates to a method of handling a substrate in a processing apparatus comprising a plurality of processing stations, comprising:
moving a transporter comprising a support part from processing station to processing station,
the transporter comprising a holding component for releasably holding an object comprising at least the substrate;
moving the object to a transfer position along a path predominantly directed in parallel to a reference axis in a reference co-ordinate system by means of at least one object movement device associated with one of the processing station;
positioning the transporter at the processing station; and
engaging, by the holding component, the object in the transfer position when the transporter is positioned at the processing station.

The invention also relates to a method, e.g. a method of the aforementioned kind, of handling a substrate in a processing apparatus comprising a plurality of processing stations, comprising:
moving a transporter comprising a support part from processing station to processing station,
the transporter comprising a holding component for releasably holding an object comprising at least the substrate;
positioning the transporter at a processing station; and
releasing, by the holding component, the object in the transfer position when the transporter is positioned at the processing station; and
moving the object from the transfer position into the processing station along a path predominantly directed in parallel to a reference axis in a reference co-ordinate system by means of at least one object movement device associated with the processing station.

### Background Art

US 9,624,594 B2 discloses a plating apparatus for plating a surface of a substrate such as a semiconductor wafer. The plating apparatus includes: a substrates holder configured to hold a substrate in a vertical position; at least one processing bath configured to process the substrate held by the substrate holder; a transporter configured to grip the substrate holder holding the substrate and horizontally transport the substrate holder; at least one lifter configured to receive the substrate holder holding the substrate from the transporter, lower the substrate holder to place the substrate holder in the processing bath, elevate the substrate holder from the processing bath after processing of the substrate and transfer the substrate holder to the transporter; and a controller configured to control operations of the transporter and the lifter. With the plating apparatus, the substrate holder holding the substrate is horizontally transported by the transporter. The substrate holder is vertically moved by the lifter, which is provided separately from the transporter. The vertical movement of the substrate holder can be performed independently of and in parallel with the horizontal transport of another substrate holder, reducing a time it takes for the transporter to transport the substrate holder. Therefore, it becomes possible to reduce a tact time and increase a throughput even if there is an increase in the number of processing baths or the number of process steps.

The following document is mentioned, as a pertinent prior art:
US 2015/013905 A1 disclosing a wet processing apparatus, such as a plating apparatus, and an etching apparatus.

As an additional prior art illustration, it is also made reference to the following document: US 9,388,504 B2

A problem of the known apparatus is that each lifter must be able to provide a large range of movement, namely sufficient to lift the substrate holder completely out of the bath with which the lifter is associated, and at reasonable speed. At the same time, there may be a requirement for some or all of the lifters to be capable of controlling the position of the substrate holder relatively accurately. Each lifter is therefore relatively expensive. This raises the overall costs of the apparatus. Furthermore, these requirements are difficult to achieve when the substrate is relatively heavy compared to a semiconductor wafer, especially if the substrate holder is also provided with heavy parts for conducting relatively large currents during electrochemical processing.

### Summary of Invention

It is an object of the invention to provide a system, processing apparatus and methods of the types defined above that allow the processing apparatus to have a relatively low height at relatively low overall costs.

This object is achieved by the system according to the invention, which is characterised in that the transporter comprises at least one actuator for moving the holding component relative to the support part along a holding component path predominantly directed in parallel to the reference axis.

For ease of explanation, it will be assumed that the reference axis is an essentially vertical reference axis. The processing stations are then open or openable at the top, to allow the object comprising the substrate to be raised out of and lowered into each processing station. In an alternative embodiment, the reference axis may be a horizontal axis.

Paths predominantly directed in parallel to the reference axis are at an angle of no more than 45° to the reference axis. In practical implementations, the angle will be below 10° or even 5°. The paths will thus be directed essentially in parallel to the reference axis.

The holding component, when holding the object, is moved relative to the support part towards the object movement device into a position corresponding to the transfer position when the transporter is located at the processing station. The holding component is moved relative to the support part, away from the object movement device and out of a position corresponding to the transfer position. Thus, the object comprising the substrate is moved over a distance along the reference axis that is the sum of the distances by which the object movement device and the holding component of the traveller move the object. The holding component of the transporter need not therefore be shaped to protrude through an opening of a processing station deep into the processing station. The holding component need protrude only a short way into the processing station from an edge of a processing station determining a limit to the holding component path. The object movement device or devices at the processing station moves the object comprising the substrate deeper into the processing station. The object movement device or devices also push the object to the transfer position after processing has finished. Because the holding component need not comprise such deeply protruding parts, the holding component path can be relatively short. Movement over only a short distance in the reference axis direction suffices for the object comprising the substrate to clear any obstacles in the way to the next processing station. The relatively short holding component path allows the conveying system to have a relatively small extent along the reference axis.

It is noted that the transporter may be configured such that the actuator need only be powered to move the holding component in one direction. Return movement in the other direction may be gravity-driven or driven by one or more resilient parts.

The system may include a control system for controlling the release and engagement at the transfer position. Alternatively, user controls may be provided, optionally in combination with a safeguarding system comprising a sensor for determining whether the object movement device is actually at a position corresponding to the transfer position. The safeguarding system may also or alternatively comprise at least one sensor for determining that the transporter is actually at a processing station, aligned with the object movement devices associated with that processing station. It is further noted that there may be more than one object movement device per processing station, including more than one object movement device for each substrate that the processing station is capable of processing at any one time. Where there is more than one object movement device per object comprising a substrate, a control or regulating system may be provided to synchronise the operation of these object movement devices.

An embodiment of the system comprises at least one guide for guiding movement of the transporter, wherein the holding component has an elongated shape extending in a direction transverse to a direction of movement of the transporter.

In particular where the object comprising at least the substrate is planar, the plane of the object can extend in a direction transverse to the direction of movement of the transporter. The processing stations can then extend over a relatively short distance parallel to the direction of movement. The processing stations are thus relatively compact as far as this dimension is concerned.

In an embodiment of the system, the holding component is provided with engagement features for engaging the object at at least two different positions.

This embodiment has the effect of countering rotation of the substrate relative to the holding component.

In an example of an embodiment in which the system comprises at least one guide for guiding movement of the transporter, the holding component has an elongated shape extending in a direction transverse to a direction of movement of the transporter and the holding component is provided with engagement features for engaging the object at at least two different positions, the different positions are different positions along a length of the holding component.

Thus, rotation about an axis parallel to the reference axis or an axis or parallel to the direction of movement is effectively countered. Where the object is essentially planar and held with its plane parallel to the reference axis, the object can be passed through a relatively narrow slit essentially parallel to the holding component without risk of hitting the edge of the slit.

In an example of any embodiment of the system in which the holding component is provided with engagement features for engaging the object at at least two different positions, the engagement features of the holding component include at least two elements shaped to present abutments facing in opposite directions along a further reference axis perpendicular to the reference axis in the reference co-ordinate system.

Movement of the object relative to the holding component in a direction parallel to the further reference axis is thus countered.

In an embodiment of the system, the holding component is provided with at least one engagement feature for releasably interlocking with at least one engagement feature of the object, and the holding component comprises at least one actuator for moving at least one of the engagement features of the holding component into and out of engagement with the engagement features of the object.

An effect is that play between the engagement features of the object and those of the holding component when the object is held by the holding component can largely be avoided. The object itself need not be provided with movable engagement features, much less an actuator.

In an embodiment of the system, the holding component comprises at least one engagement feature comprising at least an element shaped and arranged to hook behind an engagement feature of the object, in use, and at least an end of the element proximal to the object, in use, is movable laterally with respect to the reference axis.

The engagement features of the holding component can thus hook behind those of the object. The object can then be pulled out of the processing station by the holding component. Where the reference axis is a vertical reference axis, the object can in effect be hung on the engagement feature or features of the holding component.

An embodiment of the system comprises at least one substrate holder for receiving the substrate so as to leave at least part of the substrate exposed, wherein the object further comprises the substrate holder and the holding component is arranged releasably to hold the substrate holder.

As a result, there is less risk of damage to the substrate. One transporter can repeatedly engage and release the object to move the object between processing stations. Whilst the object is in a processing station and the substrate is being processed, the transporter can move a different object between processing stations. The repeated release and engagement of each object by the holding component that this configuration involves will not damage the substrate. Repeated engagement is with the substrate holder, not the substrate.

In an example of this embodiment, the substrate holder is arranged to receive a planar substrate so as to cover at least a border region of each of opposing major surfaces of the substrate along a perimeter of the substrate whilst leaving at least a section of at least one of the major surfaces exposed.

Vulnerable edges of the substrate are thus protected, as the substrate holder frames or covers each major surface of the planar substrate. Where both major surfaces are framed, the substrate can be processed on both sides simultaneously.

In an example of any embodiment of the system in which the system comprises at least one substrate holder for receiving the substrate so as to leave at least part of the substrate exposed, the object further comprises the substrate holder and the holding component is arranged releasably to hold the substrate holder, the substrate holder has a planar configuration, and the substrate holder includes a carrier part extending in a plane of the substrate holder adjacent a section of the substrate holder for receiving the substrate.

The carrier part forms the part of the substrate holder proximal to the holding component. The carrier part may itself comprise multiple elements. Such parts of the carrier part may also be integrally connected to one or more parts comprised in the section for receiving the substrate. The integrally connected parts would then be made in one piece. The section for receiving the substrate can be inserted relatively far into the processing station without parts of the object movement device or object movement devices needing to reach very far into the processing station. Instead, the object movement devices can hold or support the substrate holder via the carrier part.

In an example of this embodiment, the carrier part includes end sections projecting laterally in opposite directions with respect to the section for receiving the substrate.

This embodiment is of particular application in a vertical processing station, where the section for receiving the substrate can be suspended from the carrier part. The carrier part can be supported by the projecting end sections, e.g. on either side of the bath into which the section for receiving the substrate is submersible. This is not necessary for the holding component, which approaches the carrier part from the other side. Engagement features of the substrate holder for engagement with engagement features of the holding component can therefore be located between the projecting end sections.

In an implementation of the embodiment just discussed, the end sections are provided with features for engaging carrier parts of each of the object movement devices, and the features of the end sections are provided on a same side of the carrier part of the substrate holder as a side on which the section for receiving the substrate extends.

Where the reference axis is a vertical reference axis, the object movement devices can thus be provided with carrier parts onto which the object is simply dropped by the holding component. The object movement devices need only be capable of pushing the object to the transfer position.

In an example of this embodiment, the features for engaging carrier parts of the object movement devices are shaped to interlock with features of the carrier parts of the object movement devices to prevent relative movement in a direction parallel to a direction in which the carrier part of the substrate holder extends.

This is useful in conjunction with object movement devices arranged to move the substrate holder in a plane of the substrate during processing.

In an example of any embodiment of the system in which the system comprises at least one substrate holder for receiving the substrate so as to leave at least part of the substrate exposed, the object further comprises the substrate holder and the holding component is arranged releasably to hold the substrate holder, the substrate holder has a planar configuration, the substrate holder includes a carrier part extending in a plane of the substrate holder adjacent a section of the substrate holder for receiving the substrate, the carrier part includes end sections projecting laterally in opposite directions with respect to the section for receiving the substrate, the end sections are provided with features for engaging carrier parts of each of the object movement devices, and the features of the end sections are provided on a same side of the carrier part of the substrate holder as a side on which the section for receiving the substrate extends, the features for engaging carrier parts of the object movement devices are shaped to interlock with features of the carrier parts of the object movement devices to prevent relative movement in a direction transverse to the plane of the substrate holder.

Rotation about an axis in the plane of the substrate holder extending in a direction transverse to the carrier part can thus be prevented when the substrate holder is held by the object movement device or devices. The same is the case for movement of at least the carrier part in a direction transverse to the plane of the substrate holder.

In an example of any embodiment of the system in which the system comprises at least one substrate holder for receiving the substrate so as to leave at least part of the substrate exposed, the object further comprises the substrate holder and the holding component is arranged releasably to hold the substrate holder, the substrate holder has a planar configuration, the substrate holder includes a carrier part extending in a plane of the substrate holder adjacent a section of the substrate holder for receiving the substrate, and the carrier part includes end sections projecting laterally in opposite directions with respect to the section for receiving the substrate, the projecting end sections each comprise a section extending in a same direction relative to a central section of the carrier part of the substrate holder as the section of the substrate holder for receiving the substrate, wherein this section of each projecting end section comprises the features for engaging carrier parts of the object movement devices.

The end sections can arch over a barrier, e.g. a side wall of a bath for receiving the section of the substrate holder in which the substrate is received. The sections comprising the features for engaging carrier parts of the object movement devices extend along the barrier on an exterior side of the barrier.

In an embodiment of the system, the object movement devices associated with at least one of the processing stations are arranged to move the object at least laterally with respect to the reference axis within the processing station.

Thus, the object, in particular the substrate can be moved relative to a processing fluid in which the substrate is submerged in the processing station. Such movement is useful where the process involves diffusion, e.g. diffusion of ions in a liquid. A particular example includes plating, e.g. electroplating. The same object movement devices are used both for moving the object into and out of the processing station and for moving the object during processing. Transfer of the object between devices within the processing apparatus is therefore not required.

In an embodiment of the system, the object movement devices associated with at least one of the processing stations comprise linear actuators for moving the object along the path.

This is a relatively simple and effective way of moving the object along a straight path predominantly parallel to the reference axis.

In an example of this embodiment, linear actuators comprised in the object movement devices associated with a first of the processing stations are of a different configuration than linear actuators comprised in the object movement devices associated with a second of the processing stations.

In this embodiment, processing stations in which the object movement devices are only used to move the object into and out of the processing station can be provided with cheaper, simpler or faster-acting linear actuators than processing stations in which the object's movement or position need to be controlled more accurately. An example of the latter includes processing stations in which the object is moved over a small distance or along a complicated two-dimensional path during processing.

In an example of the embodiments of the system in which the object movement devices associated with at least one of the processing stations are arranged to move the object at least laterally with respect to the reference axis within the processing station, and the object movement devices associated with at least one of the processing stations comprise linear actuators for moving the object along the path, the object movement devices arranged to move the object laterally comprise:
respective carrier parts for engaging the object, movable relative to a respective support driven by one of the linear actuators; and
an actuator system for moving the carrier parts relative to the supports.

The object can thus be positioned laterally independently of its reference axis co-ordinate. Different shapes of movement paths can be programmed into a controller arranged to control the operation of the linear actuator or actuators and the actuator for moving the carrier part relative to the support. Thus, both a straight-line movement along the movement path essentially parallel to the reference axis and a two-dimensional movement path in a plane parallel to the reference axis can be executed.

In an example of the embodiment of the system in which the object movement devices associated with at least one of the processing stations comprise linear actuators for moving the object along the path, the object movement devices associated with at least one of the processing stations permit only movement of the object along the path.

These object movement devices can thus be relatively simple and fast-acting.

In an embodiment of the system, at least two object movement devices are associated with each processing station, located on opposite sides of the processing station and arranged to carry the object between each other, and a system for synchronising movement of the at least two object movement devices associated with the processing station is provided.

This embodiment largely prevents any tilting of the object about an axis perpendicular to the reference axis and to a plane in which the points of engagement between the object movement devices and the object lie.

In an embodiment of the system, the transporter comprises at least one holding component carrier, coupled to the holding component and guided for movement along a path corresponding to the holding component path.

Movement of the holding component other than along the holding component path is thus countered.

In a particular example of this embodiment, the transporter comprises at least two of the holding component carriers, between which the holding component is arranged.

Bending of the holding component is thus countered, in particular where the reference axis is an essentially vertical reference axis. In any event, the connection between the holding component and each carrier need not be very stiff, and can thus be a lightweight connection.

In an embodiment of the system, the object movement devices are arranged to engage the object at a level corresponding to a first position along the reference axis and the holding component is arranged to engage the object at a level corresponding to a second position along the reference axis, at a distance to the first position, when the object is in the transfer position.

The holding component and the object movement devices can thus hand over the object to each other whilst separated by a relatively large distance. This is useful where some sort of cover or other obstacle that just allows the object to pass is located between the holding component and the object movement device or devices.

An embodiment of the system comprises at least one guide for guiding movement of the transporter in a plane perpendicular to the reference axis, e.g. along an essentially straight path.

Where the reference axis is a vertical reference axis, for example, the transporter is thus arranged for movement at a constant height.

An embodiment of the system comprises at least two guides for guiding movement of the transporter, each arranged to support the transporter and arranged on opposite sides of a plane through a centre of the holding component and parallel to the reference axis and the direction of movement of the transporter.

The transporter can thus be held relatively precisely at an intended orientation relative to the reference axis. Tilting or bending that would cause the object to rotate about an axis parallel to the direction of movement past the processing stations is countered.

According to another aspect, the processing apparatus according to the invention comprises a plurality of processing stations and a system according to the invention.

The processing apparatus has a relatively small dimension in the direction of the reference axis, i.e. a relatively low height where the reference axis is a vertical axis.

In an embodiment of the processing apparatus, the transporter comprises at least one holding component carrier, coupled to the holding component and guided for movement along a carrier path corresponding to the holding component path, and the transporter is supported to maintain an end point of each carrier path proximal to the processing apparatus at a position removed from the processing apparatus in a direction parallel to the reference axis at each position of the transporter along a path of movement of the transporter past the processing stations.

The carrier path is thus completely contained within the transporter. The holding component may protrude over a short distance in a position corresponding to the transfer position.

In an embodiment of the processing apparatus, the transporter is supported to maintain the entire transporter at a position removed from the processing apparatus in a direction parallel to the reference axis at each position of the transporter along a path of movement of the transporter past the processing stations.

The transporter therefore does not straddle the processing stations, but is held at a different level. This level corresponds to a level above the processing stations where the reference axis is a vertical reference axis. As a result, a lateral dimension of the transporter is relatively small. Moreover, the processing stations are more easily accessible from directions transverse to the reference axis and the direction in which the processing stations are arranged. In particular, conduits and cables may extend to and from the processing stations from these directions without interfering with the transporter.

An embodiment of the processing apparatus comprises at least one processing station open at a top, wherein the reference axis is a vertical reference axis.

This embodiment provides the effect of limiting the height of the conveying system and processing apparatus for an object of given dimensions. The processing station may comprise a bath for receiving a processing liquid into which at least the substrate is submergible.

An embodiment of the processing apparatus comprises at least one part defining at least one elongated slit through which the object is movable into a respective one of the processing stations, e.g. a slit narrower than a maximum width of the holding component when aligned with the slit.

The transporter and the object movement devices of the processing station can be arranged on opposite sides of the slit, seen in the direction of the reference axis. Neither need be able to extend completely through the slit, so that the slit can be relatively narrow. This allows the processing stations to have only a small opening.

In an embodiment of the processing apparatus, at least one of the processing stations includes a receptacle for receiving and processing the substrate, the receptacle is provided with receptacle side walls defining a mouth through which at least the substrate is movable into and out of the receptacle, the side walls define at least one slit extending from an edge of the side wall at the mouth in a direction parallel to the reference axis, and one of the object movement devices is located outside the receptacle adjacent the slit.

The slit or slits allow the receptacle side walls to be relatively high, thus separating the interior of the receptacle from its environment relatively well. The object comprising at least the substrate can still be inserted relatively deeply into the receptacle, e.g. by means of extensions of the object that pass through the slit and by which the object can be supported by the object movement devices. The receptacle may in particular be connected to a conduit for receiving a processing fluid. The object movement device is unlikely to be contacted by the processing fluid due to the configuration of the receptacle side walls in this embodiment.

According to a third aspect, a first of the methods according to the invention is characterised by moving the holding component holding the object relative to the support part along a holding component path predominantly directed in parallel to the reference axis and away from the processing station.

Thus, the object is first lifted, e.g. pushed, some way out of the processing station by stationary object movement devices associated with that processing station. When the object reaches the transfer position, the holding component of the transporter engages the object and lifts the object further out of the processing station, until an end of the object proximal to the processing station is clear of any obstacles in a path to a next processing station to which the transporter is arranged to convey the object. The holding component need not be configured to reach deep into the processing station, because the object movement device or devices bring the object into reach of the holding component. The path of movement of the holding component relative to the support of the transporter can thus be relatively short. The transporter can therefore have a small dimension parallel to the reference axis. The transporter does not add so much to the overall height of the conveying system and processing apparatus. This effect is achieved without having to tilt the object. The object can in particular be a planar object held in an orientation in which its plane is parallel to the reference axis, both during processing and during transport between processing stations.

According to a third aspect, a second of the methods according to the invention is characterised by, before releasing the object in the transfer position, moving the holding component holding the object relative to the support part along a holding component path predominantly directed in parallel to the reference axis and towards the processing station.

This method is thus the mirror image of the first method. The second method is the method by which the object is moved into a processing station after the transporter has aligned the object with the processing station.

In an embodiment of any of the methods, the processing apparatus is a processing apparatus according to the invention.

It goes without saying that the conveying system and processing apparatus of the invention are also suitable for carrying out a method according to the invention and appropriately configured for this purpose.

### Brief Description of Drawings

The invention will be described in further detail with reference to the accompanying drawings, in which:
- Fig. 1: is a perspective view of two processing stations of a processing apparatus;
- Fig. 2: is a perspective view of a further processing station in the processing apparatus;
- Fig. 3: is a perspective view of a conveying system for conveying an object comprising a substrate between the processing stations;
- Fig. 4: is a detailed perspective view of parts of an actuator for moving a transporter of the conveying system from processing station to processing station;
- Fig. 5: is a perspective cross-sectional view of the processing station of Fig. 3 and object movement devices associated with this processing station;
- Fig. 6: is a plan cross-sectional view of the processing station and object movement devices of Fig. 5;
- Fig. 7: is a first detailed perspective view of one of the object movement devices of Figs. 5 and 6;
- Fig. 8: is a second detailed perspective view of the object movement device of Fig. 7;
- Fig. 9: is a first detailed perspective view of the other of the object movement devices of Figs. 5 and 6;
- Fig. 10: is a second detailed perspective view of the object movement device of Fig. 9;
- Fig. 11: is a perspective view, partially in cross-section, of the traveller when positioned one of the processing stations of Fig. 1;
- Fig. 12: is a plan view, partially in cross-section, of the traveller positioned at the processing station of Fig. 11, with the object in a transfer position;
- Fig. 13: is a detailed view of part of a substrate holder for receiving the substrate;
- Fig. 14: is a detailed view of the substrate holder, a holding component of the transporter and a linear actuator associated with the processing station of Figs. 11 and 12;
- Fig. 15: is a detailed view of the holding component and the substrate holder;
- Fig. 16: is a detailed plan view of the transporter at the processing station of Figs. 11-14; and
- Fig. 17: is a plan view of the holding component.

### Description of Embodiments

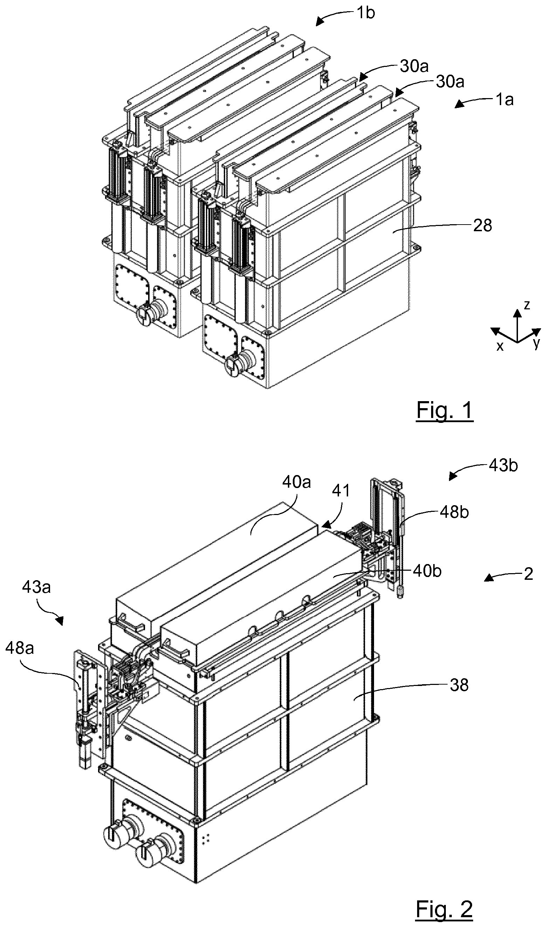

A conveying system for use with a processing apparatus comprising a plurality of processing stations 1a,b of a first type (Figs. 1, 3, 10-12 and 14) and at least one processing station 2 of a second type (Figs. 2 and 4-9) will be described using the example of a vertical wet processing apparatus for planar substrates 3. The conveying system may, however, also be used in conjunction with other types of processing apparatus comprising a plurality of processing stations 1a,b arranged in a row and open at the top to allow a substrate 3 to be raised and lowered into the processing station 1a,b.

Turning to the processing apparatus used here as an example, treatment of the substrate 3 in the apparatus may include at least one of chemical or electrolytic metal deposition, chemical or electrolytic etching and chemical or electrolytic cleaning. In a particular embodiment, the apparatus is arranged to carry out electrolytic metal deposition, chemical etching and chemical cleaning, with each of these steps taking place in a dedicated processing station 1a,b. Specifically contemplated examples of electrolytic metal deposition include galvanic deposition of copper or nickel onto a surface of a substrate 3.

Variants of the apparatus may be arranged for processing planar substrates 3 having a circular or polygonal (e.g. square or rectangular) shape. The substrate 3 may be a film or a semiconductor wafer, for example. Such a wafer may in particular have a frame-like structure obtainable by means of a so-called TAIKO process. In the illustrated example, a substrate 3 in the shape of a board is shown. The apparatus can be used to form electrically conductive traces on and/or or through the board, for example.

In the illustrated embodiment, the apparatus is a vertical plating apparatus, meaning that the substrate 3 is held in a generally vertical orientation during processing.

It is convenient to define a co-ordinate system with reference to the direction in which the processing stations 1a,b,2 are arranged, an x-axis being parallel to this direction. The reference co-ordinate system is thus stationary. The substrate 3 is held with its plane essentially parallel to the zy-plane. The processing stations 1a,b,2 can thus have a relatively large width, corresponding to their dimension in y-direction, and a shorter length, corresponding to their dimension in x-direction.

A conveying system comprising a transporter 4 moves the substrate 3 from processing station 1a,b,2 to processing station 1a,b,2. The transporter 4 comprises a transporter frame 5.

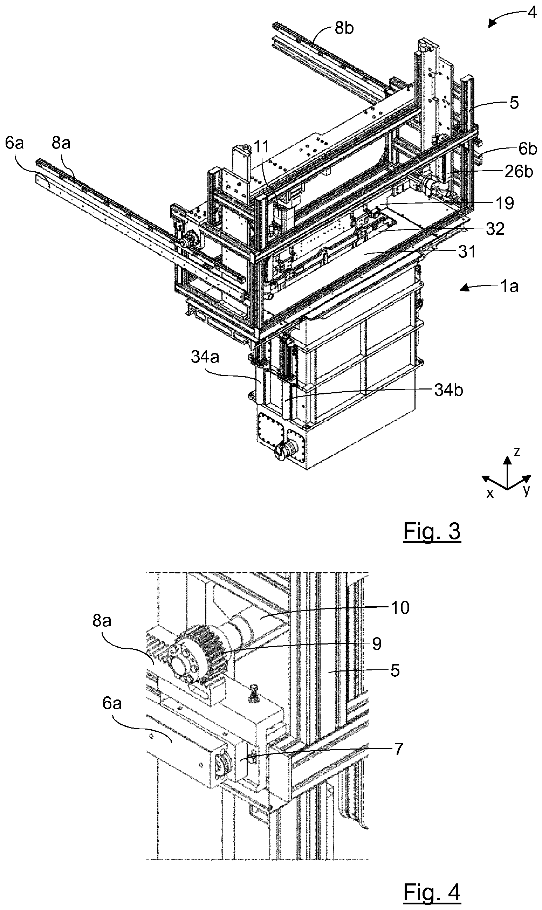

Transporter guide rails 6a,b (Fig. 3) extending in the direction of the x-axis are arranged to carry travellers 7 (Fig. 4) mounted on the transporter 4, more specifically the transporter frame 5. Racks 8a,b extend in the direction of the x-axis on either side of the transporter 4. Pinions 9 (Fig. 4) are provided at the ends of axles 10 driven by a motor 11 (Fig. 3) comprised in the transporter 4. The transporter 4 is thus arranged for linear motion in either direction along the x-axis. A coupler shoe (not shown in detail) on the transporter 4 forms part of a system for inductive power transfer to the transporter 4. This electrical power is used by the various actuators comprised in the transporter 4.

During processing, the substrate 3 is received in a substrate holder 12, so that the conveying system handles an object comprising the substrate 3 and the substrate holder 12. In this way, the conveying system need not repeatedly clamp and release the substrate 3. Damage to the substrate 3 is thereby avoided.

The substrate holder 12 shown in the example comprises two essentially identically shaped planar holding parts pressed against opposing major surfaces of the substrate 3. A section 13 of the substrate holder 12 for receiving the substrate 3 engages the substrate 3 in a border region of each of the two major surfaces of the substrate 3 along the entire perimeter of the substrate 3. The substrate holder 12 leaves a central region of each major surface exposed. The substrate holder 12 thus frames the substrate 3 on each side of the substrate 3. It is possible to use a substrate holder 12 that completely covers one of the two major surfaces of the substrate 3 instead, depending on the intended application.

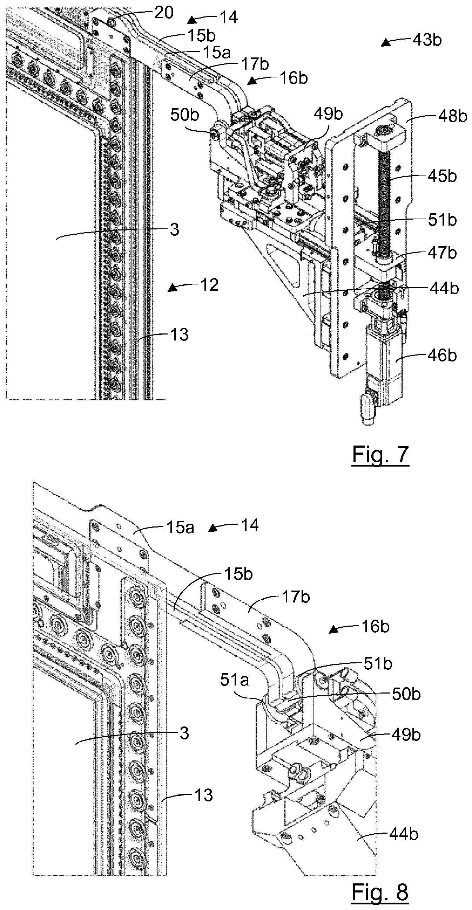

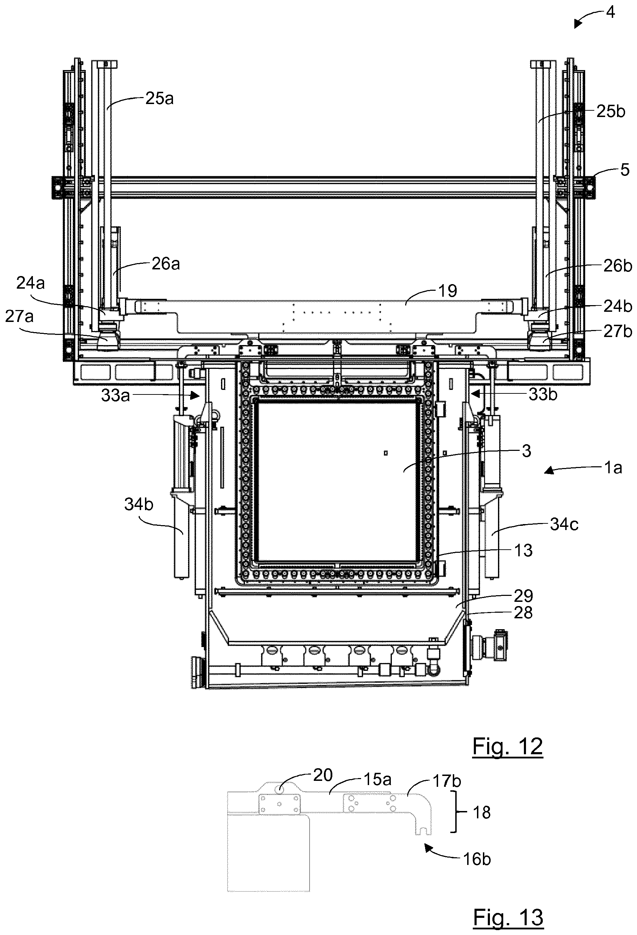

The substrate holder 12 further comprises a support part, in this case a support assembly 14 provided with features for engaging the substrate holder 12. The support assembly 14 in this example comprises two parallel bars 15a,b. These bars 15a,b extend essentially in a plane of the substrate holder 12. The support assembly 14 projects laterally in opposite directions with respect to the substrate holding parts between which the substrate 3 is held. Engagement features are provided on the projecting sections of the support assembly 14 for engaging the support assembly 14 on either side of the substrate 3 from a direction in which the substrate 3 extends relative to the support assembly 14. In the illustrated embodiment, the engagement features comprise claws 16a,b (Figs. 7-10 and 13-15) for receiving respective pins oriented with a longitudinal axis transverse to the plane of the substrate 3. In the illustrated embodiment, the claws 16a,b are formed at the end of angled extensions 17 to the substrate holder support bars 15a,b. In alternative embodiments, the claws 16a,b or similar recesses may be formed directly in an underside of the support bars 15. An end section 18 (Fig. 13) extends in a same direction relative to the substrate holder support bars 15a,b as the section 13 for receiving the substrate 3.

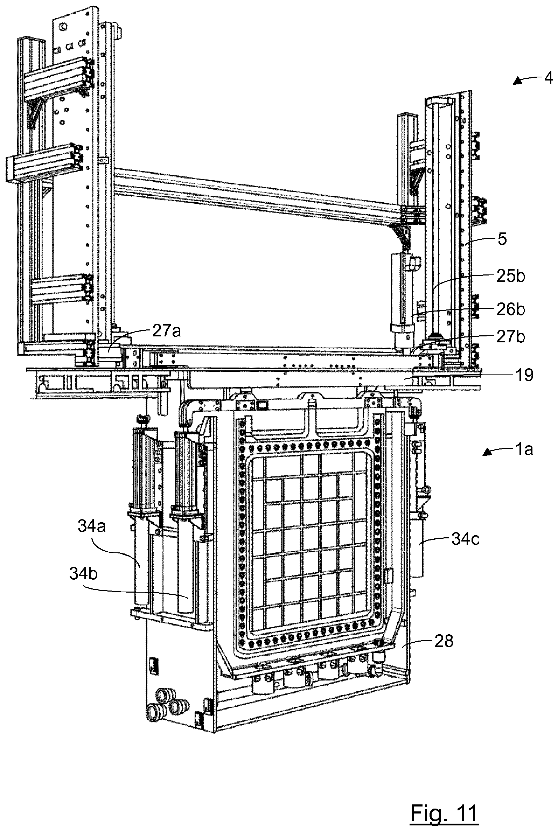

The transporter 4 comprises a holding component 19 (Figs. 11, 12 and 14-17) for releasably holding the substrate holder 12. The holding component 19 has a relatively elongated shape. The holding component 19 extends essentially in y-direction, i.e. transverse to the direction of movement of the transporter 4 past the processing stations 1a,b,2.

The substrate holder 12 is provided with further engagement features for interlocking engagement with co-operating engagement features of the holding component 19. The engagement features of the substrate holder 12 are provided at two distinct locations along the substrate holder support bars 15a,b. This essentially precludes any rotation of the substrate holder 12 about the z-axis during handling by the conveying system. Provision of the engagement features at two distinct locations also helps prevent any swinging of the substrate holder 12 in a plane of the substrate 3. As a consequence, the engagement features - in this example the claws 16a,b - can be aligned relatively accurately when the substrate holder 12 is lowered into the processing station 1a,b.

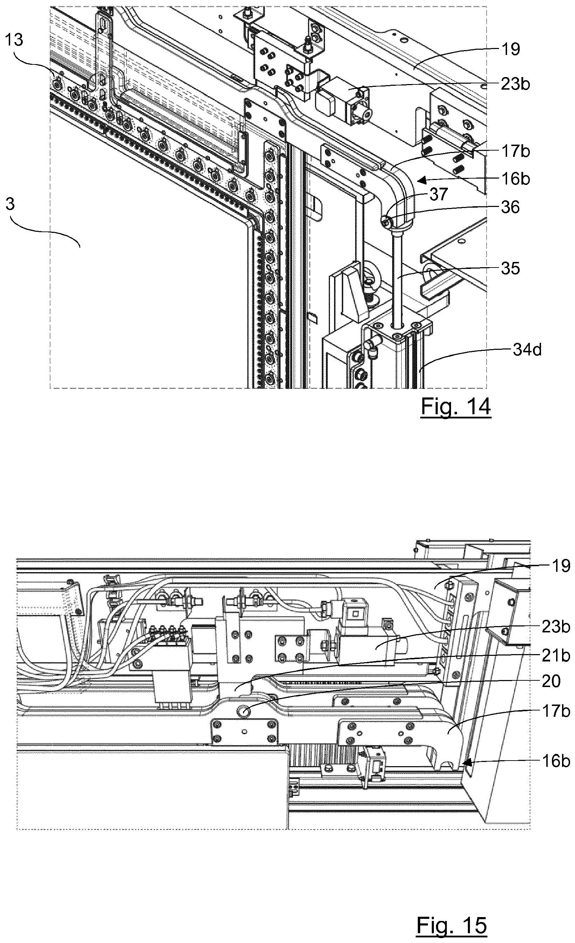

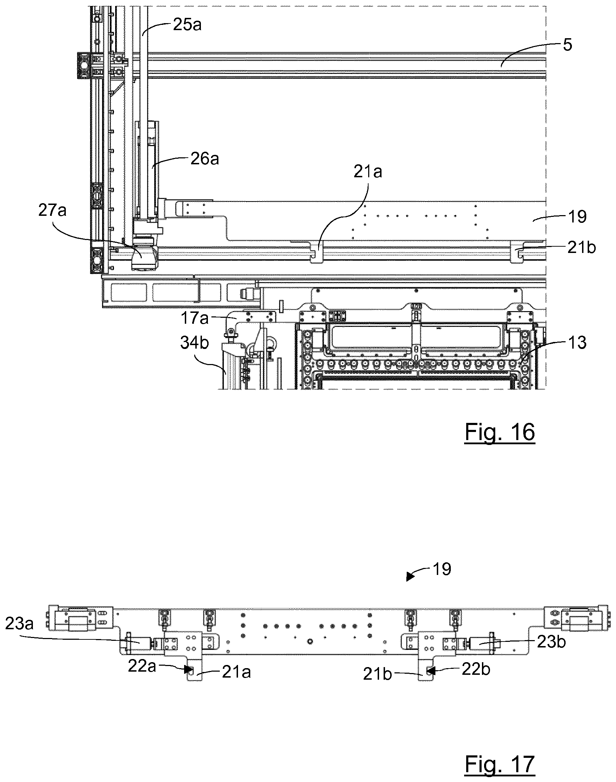

In the illustrated embodiments, the engagement features of the substrate holder 12 comprise features behind which movable engagement features of the holding component 19 can hook to allow the engagement features to interlock. In particular, the engagement features of the substrate holder 12 comprise pins 20 extending between the substrate holder support bars 15a,b. The engagement features of the holding component 19 comprise hooks 21a,b (Figs. 14-17) movably journalled to the holding component 19. The hooks 21a,b are open in opposite lateral directions (Figs. 16 and 17). The hooks 21a,b are moved in opposite directions along the y-axis to engage the pins 20 by means of inside edge sections 22a,b (Fig. 17) of the hooks 21a,b. In this way, once engaged with the pins 20, relative movement of the substrate holder 12 with respect to the holding component 19 is essentially prevented. The hooks 21a,b are moved into engagement by respective actuators 23a,b with which the holding component 19 is provided. The holding component 19 may comprise engagement features with a different shape in other embodiments, as long as they are movable in the y-direction to hook behind engagement features of the substrate holder 12. In this way, the substrate holder 12 is supported by the engagement features of the holding component 19 when suspended from the holding component 19.

The holding component 19 is movable with respect to the transporter frame 5 in z-direction. The transporter frame 4 functions as a support part of the transporter 4. A pair of carriers 24a,b (Fig. 12) is guided for linear movement with respect to the transporter frame 5, the holding component 19 is coupled to the carriers 24a,b and held between the carriers 24a,b. The transporter 4 comprises two lifting devices comprising respective actuators for moving the carriers 24a,b, and thus the holding component 19, in the z-direction. Operation of the actuators is synchronised. In an alternative embodiment, only one actuator is provided and the other carrier 24a,b is merely moved along its guide by the holding component 19.

The actuators may be electro-mechanical actuators, for example. Pneumatic or hydraulic actuators are also possible in principle, but require space for a piston. Linear actuators employing a motor and screw mechanism are relatively well-suited. The illustrated example makes use of a lead screw 25a,b having an axis of rotation extending essentially in the z-direction and rotatably journalled on the transporter frame 5. Rotary motors 26a,b are arranged to drive the lead screws 25a,b via transmission mechanisms 27a,b. The lead screws 25a,b guide movement of the carriers 24a,b, which travel along the lead screws 25a,b. The motors 26a,b thus remain stationary with respect to the transporter 4.

With this type of linear actuator, the longest element of the mechanism, namely the lead screw 25a,b is not displaced in z-direction. Alternatives with a similar effect include linear actuators comprising a mechanism comprising a rack and pinion, a belt drive or a winch. In the latter two alternatives, as is the case for the screw mechanism with rotating screw, the carriers 24a,b need not comprise the electric motors, which are instead supported by the frame.

The paths of movement of the holding component carriers 24a,b terminate at ends proximal to the processing stations 1a,b,2 , which ends are at a level (with respect to the z-axis) higher than that of a lower limit of the transporter 4, in this case of the transporter frame 5. Distal ends of the paths of movement of the holding component carriers 24a,b are at such a level that the path of movement of the holding component 19 terminates with the holding component 19 retained within the confines of the transporter 4, in this example as determined by the transporter frame 5. This level and the distance from the lower edge of the substrate holder to the distal side of the holding component 19 are sufficient for the substrate holder 12 to be maintained clear of the processing apparatus as the transporter 4 moves from processing station 1a,b,2 to processing station 1a,b,2. However, the maximum dimension of the holding component 19 is insufficient to insert the substrate holder 12 completely into at least one of the processing stations 1a,b,2. Instead, the end point of the movement path of the holding component 19 proximal to the processing stations 1a,b,2 corresponds to a transfer position of the substrate holder 12.

In the illustrated embodiment, as mentioned, there are two types of processing station 1a,b,2.

The processing stations 1a,b of a first type are for processes in which the substrate remains stationary. An example would be a rinsing process. The processing station 1a comprises an outer casing 28 and two inner receptacles 29 for forming baths for receiving at least the substrate holder section 13 in which the substrate 3 is received. Top slits 30a,b (Fig. 1) are defined at the top of the processing station 1a, through which the substrate holder 12 can pass when oriented with its plane essentially parallel to the direction of movement. The top slits 30a,b are too narrow to permit entry of the holding component 19.

In the illustrated embodiment (Fig. 3), a further cover 31 is arranged over the processing stations 1a,b. The cover 31 determines the height above which the transporter 4 and the lower edge of the substrate holder 12 are held when the transporter 4 moves past the processing stations 1a,b,2. The cover 31 is provided with cover slits 32 aligned with the top slits 30a,b. The cover slits 32 are dimensioned to allow the substrate holder 12 to pass through them. The cover slits 32 are surrounded on all sides by the cover 31, so that the holding component 19 is unable to pass through the cover slits 32.

The receptacles 29 and casing 28 are provided with side walls that leave open side wall slits 33a,b extending from a mouth of the receptacle 29a,b concerned. The side wall slits 33a,b (Fig. 12) are provided in pairs, the members of which are aligned and located on opposite sides of the receptacle 29a,b. The dimensions of the side wall slits 33a,b are sufficient to allow the carrier bar extensions 17 of the substrate holder 12 to pass through the side wall slits 33a,b.

The object movement devices of the processing stations 1a,b of the first type comprise only linear actuators 34a-d. These permit only movement of the substrate holder 12 in the z-direction, i.e. along the path of movement into and out of the processing station 1a. The linear actuators 34a-d may be pneumatic, hydraulic or electromechanical linear actuators 34a-d, for example. The linear actuators 34a-d comprise a piston 35 (Fig. 14), at a free end of which a holding pin 36 is arranged. The holding pin 36 is configured for engaging one of the claws 16a,b of the substrate holder. The holding pin 36 is provided with holding pin discs 37 presenting respective opposing surfaces between which the claw 16a,b is inserted. Thus, the engagement between the holding pin 36 and claw 16a,b prevents relative movement in x- and y-direction. In z-direction, the holding pin 36 and claw 16a,b are held in engagement only through the force of gravity.

At least the operation of the linear actuators 34a-d forming a pair for lifting one substrate holder 12 is synchronised.

The processing station 2 of a second type is for processes in which the substrate 3 is moved during processing. An example would be a plating process. In the illustrated embodiment, the movement is in the plane of the substrate 3. The movement complements or replaces agitation of the fluid in which the substrate 3 is submerged for processing. An example of the kind of movement contemplated, and a description of its effects, is provided in WO 2017/093382 A1.

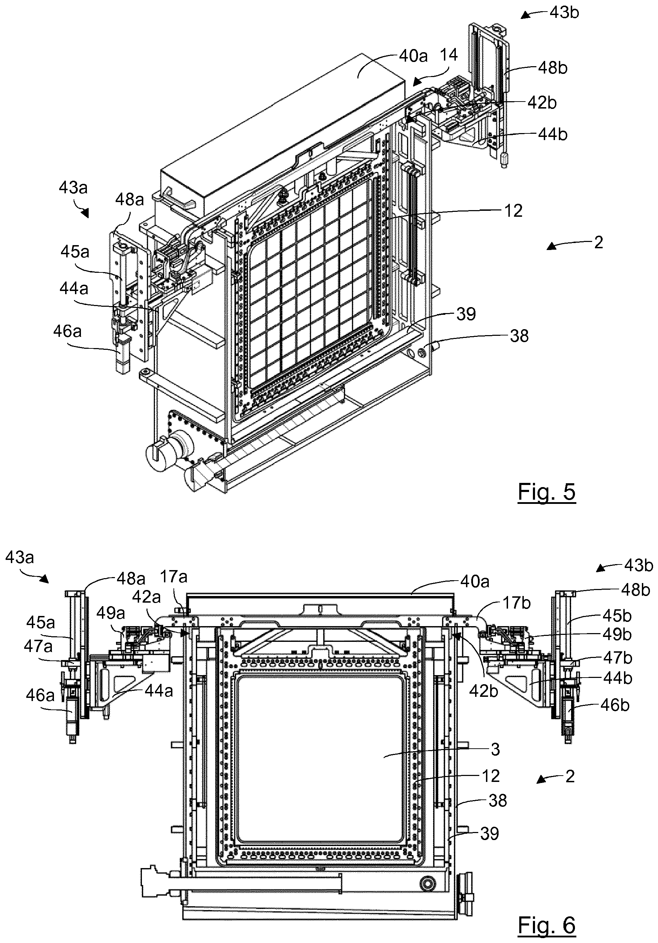

The processing station 2 comprises an outer casing 38 and an inner receptacle 39 (Figs. 5,6) for forming a bath for receiving at least the substrate holder section 13 in which the substrate 3 is received. Two removable cover parts 40a,b (Fig. 2) close most of the mouth defined by the outer casing 38 and inner receptacle 39. A top slit 41 is defined between the cover parts 40a,b. The substrate holder 12 is able to pass through the top slit 41 when oriented with its plane essentially parallel to the direction of movement. The top slits 41 is too narrow to permit entry of the holding component 19, however.

The receptacle 39 and casing 38 are provided with side walls that leave open side wall slits 42a,b (Figs. 5,6) extending from a mouth of the receptacle 39 or casing 38. The side wall slits 42a,b are provided in pairs, the members of which are aligned and located on opposite sides of the receptacle 39 and casing 38. The dimensions of the side wall slits 42a,b are sufficient to allow the carrier bar extensions 17 of the substrate holder 12 to pass through the side wall slits 33a,b.

A pair of object movement devices 43a,b is associated with the processing station 2. Each object movement device 43a,b comprises a carrier part support 44a,b and a linear actuator for moving the carrier part support 44a,b in the z-direction. In the illustrated embodiment, the linear actuators comprise screw drives, each comprising a rotating lead screw 45a,b driven by a stationary rotary motor 46a,b and a traveller 47a,b coupled to the carrier part support 44a,b. Carrier part support guides 48a,b support and guide the movement of the carrier part supports 44a,b. This type of linear actuator allows for relatively precise positioning in z-direction, so that movement of the substrate holder 12 within a small range during processing can be controlled relatively accurately. The lead screws 45a,b and carrier part support guides 48a,b are long enough to enable the substrate holder 12 also to be moved to the transfer position.

The carrier part supports 44a,b support carrier parts 49a,b provided with respective holding pins 50a,b (Figs. 7-10) for engaging the claws 16a,b of the substrate holder 12. Each holding pin 50 is provided with holding pin discs 51 presenting respective opposing surfaces between which the claw 16a,b is inserted. Thus, the engagement between the holding pin 50 and claw 16a,b prevents relative movement in x- and y-direction. In z-direction, the holding pin 50 and claw 16a,b are held in engagement only through the force of gravity.

The holding pins 50 are electrically conducting and connected to power supplies (not shown). The holding pin discs 51 are electrically insulating.

The carrier parts 49a,b are movably journalled on the carrier part supports 44a,b such as to permit only movement in the y-direction.

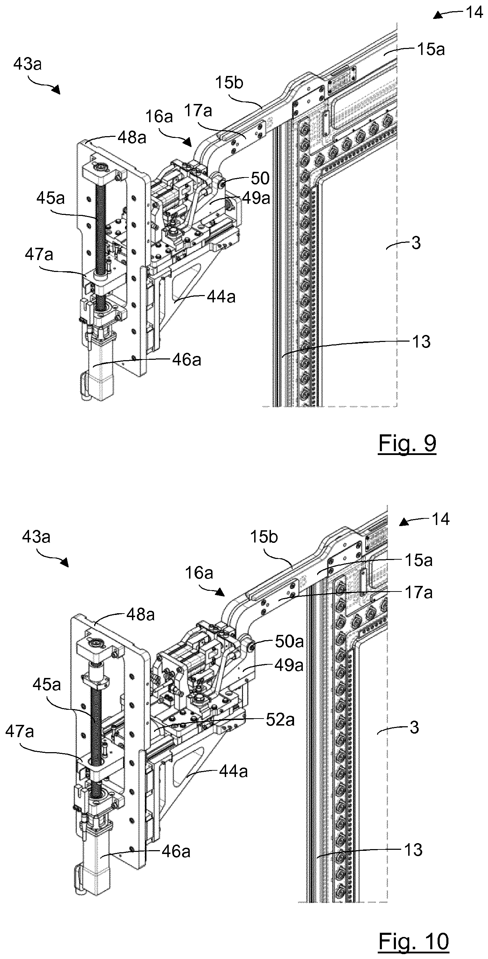

Actuators 52a,b (Figs. 7 and 10) are provided to drive the movement. The operation of the object movement devices 43a,b responsible for moving the substrate holder 12 in y- and z-direction within the processing station 2 is synchronised. Figs. 9 and 10 show the end positions of the carrier part 49a driven by the actuator 52a.

As is the case for the processing stations 1a,b of the first type, the object movement devices 43a,b of the processing station 2 of the second type are arranged to lift the substrate holder 12 to the transfer position, where the holding component 19 engages the substrate holder 12 to lift the substrate holder 12 further out of the processing station 2. Thus, the holding component 19 can have a relatively low height and short path of movement relative to the transporter 4. The transporter 4 can thus have a relatively low height, so that the processing apparatus with the conveying system can be placed in a hall with a relatively low ceiling.

The invention is defined by the appended claims. Various embodiments can be considered as long they belong to the scope of said invention.

### List of reference numerals

- 1a,b: - processing stations of a first type
- 2: - processing stations of a second type
- 3: - substrate
- 4: - transporter
- 5: - transporter frame
- 6a,b: - transporter guide rails
- 7: - traveller
- 8a,b: - racks
- 9: - pinion
- 10: - axle
- 11: - transporter motor
- 12: - substrate holder
- 13: - substrate holder section for receiving the substrate
- 14: - substrate holder support assembly
- 15a,b: - substrate holder support bar
- 16a,b: - claws
- 17a,b: - bar extensions
- 18: - end section of bar extension
- 19: - holding component
- 20: - substrate holder pins
- 21a,b: - holding component hooks
- 22a,b: - inside edge section
- 23a,b: - holding component actuators
- 24a,b: - holding component carriers
- 25a,b: - transporter lead screws
- 26a,b: - rotary motors
- 27a,b: - transmission mechanisms
- 28: - processing station casing
- 29: - receptacle
- 30a,b: - top slit
- 31: - processing station cover
- 32: - cover slit
- 33a,b: - side wall slits
- 34a-d: - linear actuators
- 35: - piston
- 36: - holding pin
- 37: - holding pin disc
- 38: - processing station casing
- 39: - receptacle
- 40a,b: - cover parts
- 41: - top slit
- 42: - side wall slits
- 43a,b: - object movement devices
- 44a,b: - carrier part supports
- 45a,b: - lead screws
- 46a,b: - rotary motors
- 47a,b: - travellers
- 48a,b: - carrier part support guides
- 49a,b: - carrier parts
- 50a,b: - holding pins
- 51a,b: - holding pin disc
- 52a,b: - carrier part actuators

## Claims

1. System for conveying an object comprising at least a substrate (3) between processing stations (1a,b;2) of a processing apparatus, comprising:
a transporter (4), arranged for movement from processing station to processing station (1a,b;2),
wherein the transporter (4) comprises a support part (5) and a holding component (19) for releasably holding the object; and
at least one object movement device (34a-d;43a,b) for moving the object along a path predominantly directed in parallel to a reference axis (z) in a reference co-ordinate system,
wherein each object movement device (34a-d;43a,b) is associated with a respective processing station (1a,b;2) and capable of moving the object along the path towards the transporter (4) to a transfer position and towards the associated processing station (1a,b;2) from the transfer position, and
wherein the holding component (19) is configured to release and engage the object in the transfer position when the transporter (4) is positioned at the processing station (1a,b;2),
the transporter (4) comprising at least one actuator (25a,b,26a,b,27a,b) for moving the holding component (19) relative to the support part (5) along a holding component path predominantly directed in parallel to the reference axis (z).

2. System according to claim 1,
comprising at least one guide (6a,b) for guiding movement of the transporter (4), wherein the holding component (19) has an elongated shape extending in a direction (y) transverse to a direction of movement of the transporter (4).

3. System according to claim 1 or 2,
wherein the object movement devices (43a,b) associated with at least one of the processing stations (2) are arranged to move the object at least laterally with respect to the reference axis (z) within the processing station (2).

4. System according to any one of the preceding claims,
wherein the object movement devices (34a-d;43a,b) associated with at least one of the processing stations (1a,b;2) comprise linear actuators (34a-d;45a,b,46a,b, 47a,b,48a,b) for moving the object along the path.

5. System according to claim 4,
wherein linear actuators (34a-d;45a,b,46a,b, 47a,b,48a,b) comprised in the object movement devices (34a-d;43a,b) associated with a first of the processing stations (1a,b;2) are of a different configuration than linear actuators (34a-d;45a,b,46a,b,47a,b,48a,b) comprised in the object movement devices (34a-d;43a,b) associated with a second of the processing stations (1a,b;2).

6. System according to claim 3 and any one of claims 4 and 5,
wherein the object movement devices (34a-d;43a,b) arranged to move the object laterally comprise:
respective carrier parts (49a,b) for engaging the object, movable relative to a respective support (44a,b) driven by one of the linear actuators (45a,b,46a,b, 47a,b,48a,b); and
an actuator system (52a,b) for moving the carrier parts (49a,b) relative to the supports (44a,b).

7. System according to claim 4 or 5,
wherein the object movement devices (34a-d) associated with at least one of the processing stations (1a,b) permit only movement of the object along the path.

8. System according to any one of the preceding claims,
wherein the object movement devices (34a-d;43a,b) are arranged to engage the object at a level corresponding to a first position along the reference axis (z) and the holding component (19) is arranged to engage the object at a level corresponding to a second position along the reference axis (z), at a distance to the first position, when the object is in the transfer position.

9. Processing apparatus comprising a plurality of processing stations (1a,b;2) and a system according to any one of the preceding claims.

10. Processing apparatus according to claim 9,
wherein the transporter (4) comprises at least one holding component carrier (24a,b), coupled to the holding component (19) and guided for movement along a carrier path corresponding to the holding component path, and
wherein the transporter (4) is supported to maintain an end point of each carrier path proximal to the processing apparatus at a position removed from the processing apparatus in a direction parallel to the reference axis at each position of the transporter (4) along a path of movement of the transporter (4) past the processing stations (1a,b;2).

11. Processing apparatus according to claim 9 or 10,
wherein the transporter (4) is supported to maintain the entire transporter (4) at a position removed from the processing apparatus in a direction parallel to the reference axis at each position of the transporter (4) along a path of movement of the transporter (4) past the processing stations (1a,b,2).

12. Processing apparatus according to any one of claims 9-11,
comprising at least one processing station (1a,b,2) open at a top, wherein the reference axis (z) is a vertical reference axis.

13. Processing apparatus according to any one of claims 9-12,
comprising at least one part (29;31;40a,b) defining at least one elongated slit (30;32;41) through which the object is movable into a respective one of the processing stations (1a,b;2), e.g. a slit (30;32;41) narrower than a maximum width of the holding component (19) when aligned with the slit (30;32;41).

14. Method of handling a substrate (3) in a processing apparatus comprising a plurality of processing stations (1a,b;2), comprising:
moving a transporter (4) comprising a support part (5) from processing station (1a,b;2) to processing station (1a,b;2),
the transporter (4) comprising a holding component (19) for releasably holding an object comprising at least the substrate (3);
moving the object to a transfer position along a path predominantly directed in parallel to a reference axis (z) in a reference co-ordinate system by means of at least one object movement device (34a-d,43a,b) associated with one of the processing station (1a,b;2);
positioning the transporter (4) at the processing station (1a,b;2); and
engaging, by the holding component (19), the object in the transfer position when the transporter (4) is positioned at the processing station (1a, b, 2),
moving the holding component (19) holding the object relative to the support part (5) along a holding component path predominantly directed in parallel to the reference axis (z) and away from the processing station (1a,b;2).

15. Method, e.g. according to claim 14, of handling a substrate (3) in a processing apparatus comprising a plurality of processing stations (1a,b;2), comprising:
moving a transporter (4) comprising a support part (5) from processing station (1a,b;2) to processing station (1a,b;2),
the transporter (4) comprising a holding component (19) for releasably holding an object comprising at least the substrate (3);
positioning the transporter (4) at a processing station (1a,b;2); and
releasing, by the holding component (19), the object in the transfer position when the transporter (4) is positioned at the processing station (1a,b;2); and
moving the object from the transfer position into the processing station (1a,b;2) along a path predominantly directed in parallel to a reference axis (z) in a reference co-ordinate system by means of at least one object movement device (34a-d,43a,b) associated with the processing station (1a,b;2), and
before releasing the object in the transfer position, moving the holding component (19) holding the object relative to the support part (5) along a holding component path predominantly directed in parallel to the reference axis (z) and towards the processing station (1a,b;2).

## Patentansprüche

1. System zum Fördern eines Objekts, umfassend mindestens ein Substrat (3), zwischen Verarbeitungsstationen (1a,b;2) einer Verarbeitungseinrichtung, umfassend:
einen Transporter (4), der für eine Bewegung aus der Verarbeitungsstation zu der Verarbeitungsstation (1a,b;2) angeordnet ist,
wobei der Transporter (4) ein Stützteil (5) und eine Haltekomponente (19) zum lösbaren Halten des Objekts umfasst; und
mindestens eine Objektbewegungsvorrichtung (34a-d;43a,b) zum Bewegen des Objekts entlang eines Pfads, der überwiegend parallel zu einer Referenzachse (z) in einem Referenzkoordinatensystem gerichtet ist,
wobei jede Objektbewegungsvorrichtung (34a-d;43a,b) einer jeweiligen Verarbeitungsstation (1a,b;2) zugeordnet ist und in der Lage ist, das Objekt entlang des Pfads zu dem Transporter (4) hin zu einer Übergabeposition und zu der zugeordneten Verarbeitungsstation (1a,b;2) hin von der Übergabeposition zu bewegen, und
wobei die Haltekomponente (19) konfiguriert ist, um das Objekt in der Übergabeposition zu lösen und in Eingriff zu nehmen, wenn der Transporter (4) an der Verarbeitungsstation (1a,b;2) positioniert ist, der Transporter (4) umfassend mindestens einen Aktuator (25a,b,26a,b,27a,b) zum Bewegen der Haltekomponente (19) relativ zu dem Stützteil (5) entlang eines Haltekomponentenpfads, der überwiegend parallel zu der Referenzachse (z) gerichtet ist.

2. System nach Anspruch 1,
umfassend mindestens eine Führung (6a,b) zum Führen der Bewegung des Transporters (4), wobei die Haltekomponente (19) eine längliche Form aufweist, die sich in einer Richtung (y) quer zu einer Bewegungsrichtung des Transporters (4) erstreckt.

3. System nach Anspruch 1 oder 2,
wobei die Objektbewegungsvorrichtungen (43a,b), die mindestens einer der Verarbeitungsstationen (2) zugeordnet sind, angeordnet sind, um das Objekt mindestens seitlich in Bezug auf die Referenzachse (z) innerhalb der Verarbeitungsstation (2) zu bewegen.

4. System nach einem der vorstehenden Ansprüche,
wobei die Objektbewegungsvorrichtungen (34a-d;43a, b), die mindestens einer der Verarbeitungsstationen (1a,b;2) zugeordnet sind, lineare Aktuatoren (34a-d;45a,b,46a,b,47a,b,48a,b) zum Bewegen des Objekts entlang des Pfads umfassen.

5. System nach Anspruch 4,
wobei lineare Aktuatoren (34a-d;45a,b,46a,b,47a,b,48a,b), die in den Objektbewegungsvorrichtungen (34a-d;43a,b) umfasst sind, die einer ersten der Verarbeitungsstationen (1a,b;2) zugeordnet sind, eine unterschiedliche Konfiguration aufweisen als lineare Aktuatoren (34a-d;45a,b,46a,b,47a,b,48a,b), die in den Objektbewegungsvorrichtungen (34a-d;43a,b) umfasst sind, die einer zweiten der Verarbeitungsstationen (1a,b;2) zugeordnet sind.

6. System nach Anspruch 3 und nach einem der Ansprüche 4 und 5,
wobei die Objektbewegungsvorrichtungen (34a-d;43a, b), die angeordnet sind, um das Objekt seitlich zu bewegen, umfassen:
jeweilige Trägerteile (49a, b) zum Ineingriffnehmen des Objekts, die relativ zu einer jeweiligen Stütze (44a,b) bewegbar sind, der durch einen der linearen Aktuatoren (45a,b,46a,b,47a,b,48a,b) angetrieben wird; und
ein Aktuatorsystem (52a,b) zum Bewegen der Trägerteile (49a,b) relativ zu den Stützen (44a,b).

7. System nach Anspruch 4 oder 5,
wobei die Objektbewegungsvorrichtungen (34a-d), die mindestens einer der Verarbeitungsstationen (1a,b) zugeordnet sind, nur eine Bewegung des Objekts entlang des Pfads zulassen.

8. System nach einem der vorstehenden Ansprüche,
wobei die Objektbewegungsvorrichtungen (34a-d;43a,b) angeordnet sind, um das Objekt auf einer Ebene in Eingriff zu nehmen, die einer ersten Position entlang der Referenzachse (z) entspricht, und die Haltekomponente (19) angeordnet ist, um das Objekt auf einer Ebene, die einer zweiten Position entlang der Referenzachse (z) entspricht, in einem Abstand zu der ersten Position in Eingriff zu nehmen, wenn das Objekt in der Übergabeposition ist.

9. Verarbeitungseinrichtung, umfassend eine Vielzahl von Verarbeitungsstationen (1a,b;2) und ein System nach einem der vorstehenden Ansprüche.

10. Verarbeitungseinrichtung nach Anspruch 9,
wobei der Transporter (4) mindestens einen Haltekomponententräger (24a,b) umfasst, der mit der Haltekomponente (19) gekoppelt ist und für die Bewegung entlang eines Trägerpfads, der dem Haltekomponentenpfad entspricht, geführt ist, und
wobei der Transporter (4) gestützt wird, um einen Endpunkt jedes Trägerpfads proximal zu der Verarbeitungseinrichtung an einer Position aufrechtzuerhalten, die von der Verarbeitungseinrichtung in einer Richtung parallel zu der Referenzachse an jeder Position des Transporters (4) entlang eines Bewegungspfads des Transporters (4) an den Verarbeitungsstationen (1a,b;2) vorbei entfernt wird.

11. Verarbeitungseinrichtung nach Anspruch 9 oder 10,
wobei der Transporter (4) gestützt wird, um den gesamten Transporter (4) an einer Position aufrechtzuerhalten, die von der Verarbeitungseinrichtung in einer Richtung parallel zu der Referenzachse an jeder Position des Transporters (4) entlang eines Bewegungspfads des Transporters (4) an den Verarbeitungsstationen (1a,b,2) vorbei entfernt wird.

12. Verarbeitungseinrichtung nach einem der Ansprüche 9 bis 11,
umfassend mindestens eine Verarbeitungsstation (1a,b,2) die oben offen ist,
wobei die Referenzachse (z) eine vertikale Referenzachse ist.

13. Verarbeitungseinrichtung nach einem der Ansprüche 9 bis 12,
umfassend mindestens ein Teil (29;31;40a,b), das mindestens einen länglichen Schlitz (30;32;41) definiert, durch den das Objekt in eine jeweilige der Verarbeitungsstationen (1a,b;2) bewegbar ist, z. b. einen Schlitz (30;32;41), der schmaler als eine maximale Breite der Haltekomponente (19) ist, wenn sie mit dem Schlitz (30;32;41) ausgerichtet ist.

14. Verfahren zum Handhaben eines Substrats (3) in einer Verarbeitungseinrichtung, umfassend eine Vielzahl von Verarbeitungsstationen (1a,b;2), umfassend:
Bewegen eines Transporters (4), umfassend ein Stützteil (5), aus der Verarbeitungsstation (1a,b;2) zu der Verarbeitungsstation (1a,b;2),
der Transporter (4) umfassend eine Haltekomponente (19) zum lösbaren Halten eines Objekts, umfassend mindestens das Substrat (3);
Bewegen des Objekts zu einer Übergabeposition entlang eines Pfads, der überwiegend parallel zu einer Referenzachse (z) in einem Referenzkoordinatensystem gerichtet ist, mittels mindestens einer Objektbewegungsvorrichtung (34a-d,43a,b), die einer der Verarbeitungsstation (1a,b;2) zugeordnet ist;
Positionieren des Transporters (4) an der Verarbeitungsstation (1a,b;2); und
Ineingriffnehmen, durch die Haltekomponente (19), des Objekts in der Übergabeposition, wenn der Transporter (4) an der Verarbeitungsstation (1a,b,2) positioniert ist,
Bewegen der Haltekomponente (19), die das Objekt relativ zu dem Stützteil (5) hält, entlang eines Haltekomponentenpfads, der überwiegend parallel zu der Referenzachse (z) und von der Verarbeitungsstation (1a,b;2) weg gerichtet ist.

15. Verfahren, z. b. nach Anspruch 14, zum Handhaben eines Substrats (3) in einer Verarbeitungseinrichtung, umfassend eine Vielzahl von Verarbeitungsstationen (1a,b;2), umfassend:
Bewegen eines Transporters (4), umfassend ein Stützteil (5), aus der Verarbeitungsstation (1a,b;2) zu der Verarbeitungsstation (1a,b;2),
der Transporter (4) umfassend eine Haltekomponente (19) zum lösbaren Halten eines Objekts, umfassend mindestens das Substrat (3);
Positionieren des Transporters (4) an einer Verarbeitungsstation (1a,b;2); und
Lösen, durch die Haltekomponente (19), des Objekts in der Übergabeposition, wenn der Transporter (4) an der Verarbeitungsstation (1a,b;2) positioniert ist; und
Bewegen des Objekts von der Übergabeposition in die Verarbeitungsstation (1a,b;2) entlang eines Pfads, der überwiegend parallel zu einer Referenzachse (z) in einem Referenzkoordinatensystem gerichtet ist, mittels mindestens einer Objektbewegungsvorrichtung (34a-d,43a,b), die der Verarbeitungsstation (1a,b;2) zugeordnet ist, und
vor dem Lösen des Objekts in der Übergabeposition, Bewegen der Haltekomponente (19), die das Objekt relativ zu dem Stützteil (5) hält, entlang eines Haltekomponentenpfads, der überwiegend parallel zu der Referenzachse (z) und zu der Verarbeitungsstation (1a,b;2) hin gerichtet ist.

## Revendications

1. Système permettant d'acheminer un objet comprenant au moins un substrat (3) entre des postes de traitement (1a,b ;2) d'un appareil de traitement, comprenant :
un transporteur (4), agencé pour un déplacement allant d'un poste de traitement à un poste de traitement (1a,b ;2),
dans lequel le transporteur (4) comprend une partie de support (5) et un composant de maintien (19) permettant de maintenir de manière libérable l'objet ; et
au moins un dispositif de déplacement d'objet (34a-d ;43a,b) permettant de déplacer l'objet le long d'un trajet dirigé principalement en parallèle à un axe de référence (z) dans un système de coordonnées de référence,
dans lequel chaque dispositif de déplacement d'objet (34a-d ;43a,b) est associé à un poste de traitement (1a,b ;2) respectif et est capable de déplacer l'objet le long du trajet en direction du transporteur (4) jusqu'à une position de transfert et en direction du poste de traitement (1a,b ;2) associé à partir de la position de transfert, et
dans lequel le composant de maintien (19) est configuré pour libérer et venir en prise avec l'objet dans la position de transfert lorsque le transporteur (4) est positionné au niveau du poste de traitement (1a,b ;2), le transporteur (4) comprenant au moins un actionneur (25a,b,26a,b,27a,b) permettant de déplacer le composant de maintien (19) par rapport à la partie de support (5) le long d'un trajet de composant de maintien dirigé principalement en parallèle à l'axe de référence (z).

2. Système selon la revendication 1,
comprenant au moins un guide (6a,b) permettant de guider un déplacement du transporteur (4), dans lequel le composant de maintien (19) a une forme allongée s'étendant dans une direction (y) transversale à une direction de déplacement du transporteur (4).

3. Système selon la revendication 1 ou 2,
dans lequel les dispositifs de déplacement d'objet (43a,b) associés à au moins l'un des postes de traitement (2) sont agencés pour déplacer l'objet au moins latéralement par rapport à l'axe de référence (z) au sein du poste de traitement (2).

4. Système selon l'une quelconque des revendications précédentes,
dans lequel les dispositifs de déplacement d'objet (34a-d ;43a,b) associés à au moins l'un des postes de traitement (1a,b ;2) comprennent des actionneurs linéaires (34a-d ;45a,b,46a,b,47a,b,48a,b) permettant de déplacer l'objet le long du trajet.

5. Système selon la revendication 4,
dans lequel des actionneurs linéaires (34a-d ;45a,b,46a,b,47a,b,48a,b) compris dans les dispositifs de déplacement d'objet (34a-d ;43a,b) associés à un premier des postes de traitement (1a,b ;2) sont d'une configuration différente de celle des actionneurs linéaires (34a-d ;45a,b,46a,b,47a,b,48a,b) compris dans les dispositifs de déplacement d'objet (34a-d ;43a,b) associés à un second des postes de traitement (1a,b ;2).

6. Système selon la revendication 3 et l'une quelconque des revendications 4 et 5,
dans lequel les dispositifs de déplacement d'objet (34a-d ;43a,b) agencés pour déplacer l'objet latéralement comprennent :
des parties porteuses (49a,b) respectives permettant de venir en prise avec l'objet, déplaçables par rapport à un support (44a,b) respectif entraîné par l'un des actionneurs linéaires (45a,b,46a,b,47a,b,48a,b) ; et
un système d'actionneur (52a,b) permettant de déplacer les parties porteuses (49a,b) par rapport aux supports (44a,b).

7. Système selon la revendication 4 ou 5,
dans lequel les dispositifs de déplacement d'objet (34a-d) associés à au moins l'un des postes de traitement (1a,b) permettent un déplacement de l'objet uniquement le long du trajet.

8. Système selon l'une quelconque des revendications précédentes,
dans lequel les dispositifs de déplacement d'objet (34a-d ;43a,b) sont agencés pour venir en prise avec l'objet à un niveau correspondant à une première position le long de l'axe de référence (z) et le composant de maintien (19) est agencé pour venir en prise avec l'objet à un niveau correspondant à une seconde position le long de l'axe de référence (z), à une distance de la première position, lorsque l'objet est dans la position de transfert.

9. Appareil de traitement comprenant une pluralité de postes de traitement (1a,b ;2) et un système selon l'une quelconque des revendications précédentes.

10. Appareil de traitement selon la revendication 9,
dans lequel le transporteur (4) comprend au moins un porteur de composant de maintien (24a,b), accouplé au composant de maintien (19) et guidé pour un déplacement le long d'un trajet de porteur correspondant au trajet de composant de maintien, et
dans lequel le transporteur (4) est supporté pour garder un point de fin de chaque trajet de porteur proximal par rapport à l'appareil de traitement au niveau d'une position retirée de l'appareil de traitement dans une direction parallèle à l'axe de référence au niveau de chaque position du transporteur (4) le long d'un trajet de déplacement du transporteur (4) au-delà des postes de traitement (1a,b ;2).

11. Appareil de traitement selon la revendication 9 ou 10,
dans lequel le transporteur (4) est supporté pour garder le transporteur (4) entier au niveau d'une position retirée de l'appareil de traitement dans une direction parallèle à l'axe de référence au niveau de chaque position du transporteur (4) le long d'un trajet de déplacement du transporteur (4) au-delà des postes de traitement (1a,b,2).

12. Appareil de traitement selon l'une quelconque des revendications 9 à 11,
comprenant au moins un poste de traitement (1a,b,2) ouvert au niveau d'une partie supérieure,
dans lequel l'axe de référence (z) est un axe de référence vertical.

13. Appareil de traitement selon l'une quelconque des revendications 9 à 12,
comprenant au moins une partie (29 ;31 ;40a,b) définissant au moins une fente (30 ;32 ;41) allongée à travers laquelle l'objet peut être déplacé dans l'un respectif des postes de traitement (1a,b ;2), par exemple une fente (30 ;32 ;41) plus étroite qu'une largeur maximale du composant de maintien (19) lorsqu'il est aligné avec la fente (30 ;32 ;41).

14. Procédé de manipulation d'un substrat (3) dans un appareil de traitement comprenant une pluralité de postes de traitement (1a,b ;2), comprenant :
le déplacement d'un transporteur (4) comprenant une partie de support (5) à partir d'un poste de traitement (1a,b ;2) vers un poste de traitement (1a,b ;2),
le transporteur (4) comprenant un composant de maintien (19) permettant de maintenir de manière libérable un objet comprenant au moins le substrat (3) ;
le déplacement de l'objet vers une position de transfert le long d'un trajet dirigé principalement en parallèle à un axe de référence (z) dans un système de coordonnées de référence au moyen d'au moins un dispositif de déplacement d'objet (34a-d,43a,b) associé à l'un des postes de traitement (1a,b ;2) ;
le positionnement du transporteur (4) au niveau du poste de traitement (1a,b ;2) ; et
la mise en prise, par le composant de maintien (19), de l'objet dans la position de transfert lorsque le transporteur (4) est positionné au niveau du poste de traitement (1a, b, 2),
le déplacement du composant de maintien (19) maintenant l'objet par rapport à la partie de support (5) le long d'un trajet de composant de maintien dirigé principalement en parallèle à l'axe de référence (z) et à l'écart du poste de traitement (1a,b ;2).

15. Procédé, par exemple selon la revendication 14, de manipulation d'un substrat (3) dans un appareil de traitement comprenant une pluralité de postes de traitement (1a,b ;2), comprenant :
le déplacement d'un transporteur (4) comprenant une partie de support (5) à partir d'un poste de traitement (1a,b ;2) vers un poste de traitement (1a,b ;2),
le transporteur (4) comprenant un composant de maintien (19) permettant de maintenir de manière libérable un objet comprenant au moins le substrat (3) ;
le positionnement du transporteur (4) au niveau d'un poste de traitement (1a,b ;2) ; et
la libération, par le composant de maintien (19), de l'objet dans la position de transfert lorsque le transporteur (4) est positionné au niveau du poste de traitement (1a,b ;2) ; et
le déplacement de l'objet à partir de la position de transfert vers le poste de traitement (1a,b ;2) le long d'un trajet dirigé principalement en parallèle à un axe de référence (z) dans un système de coordonnées de référence au moyen d'au moins un dispositif de déplacement d'objet (34a-d,43a,b) associé au poste de traitement (1a,b ;2), et
avant libération de l'objet dans la position de transfert, le déplacement du composant de maintien (19) maintenant l'objet par rapport à la partie de support (5) le long d'un trajet de composant de maintien dirigé principalement en parallèle à l'axe de référence (z) et en direction du poste de traitement (1a,b ;2).
